# EUROPEAN PATENT APPLICATION

(11) **EP 2 983 211 A1**
(43) Date of publication of application: **10.02.2016**
(21) Application number: 14778331.0
(22) Date of filing: 20.03.2014
(51) Int. Cl.: H01L 31/0392, H01L 31/0749

(54) **THIN-FILM SOLAR CELL**

(30) Priority: 03.04.2013 JP 2013078104
(71) Applicant: Solar Frontier K.K., Minato-ku Tokyo 135-8074 (JP)
(72) Inventor: ASANO, Akihiko, Tokyo 135-8074 (JP); YAMAURA, Toshiaki, Tokyo 135-8074 (JP); SUNAYAMA, Hideki, Tokyo 135-8074 (JP); SAITOU, Masahiro, Tokyo 135-8074 (JP)
(74) Representative: Beder, Jens
(86) International application number: PCT/JP2014/057850
(87) International publication number: WO 2014/162899

(57) **Abstract**

A thin-film photovoltaic cell includes a metal substrate; a glass insulating layer formed on the metal substrate; a first electrode layer deposited on the glass insulating layer; a thin-film light absorption layer deposited on the first electrode layer; and a second electrode layer deposited on the thin-film light absorption layer, wherein the coefficient of thermal expansion of the glass insulating layer is larger than the coefficient of thermal expansion of the metal substrate for a predetermined value.

## Description

### BACKGROUND OF THE INVENTION

### 1. Field of the Invention

The present invention relates to a thin-film photovoltaic cell.

### 2. Description of the Related Art

Thin-film photovoltaic cells are widely known, each having a structure in which a thin-film light absorption layer or the like is formed on a metal substrate via a glass insulating layer (Patent Document 1, for example). There is a problem of generation of warp by heat for such a structure in which the glass insulating layer is formed on the metal substrate. It has become a new challenge to suppress generation even for warp with a small curvature, which was not previously a problem, as the absolute amount becomes large in accordance with increasing of size of the metal substrate.

Warp is generated because there is a difference between coefficients of thermal expansion of the metal substrate and the glass insulating layer, and it is recognized, generally, that warp is generated in a step of forming the glass insulating layer on the metal substrate.

When the warp is generated in the metal substrate, the following problems occur. If the warp remains as it is, handling is difficult, and further, if a film is deposited thereon, quality of the film of such a layer becomes nonuniform. Further, although it is possible to compensate the warp of the metal substrate by a correction process, if the correction process is performed, cracks may be generated in the already deposited film and the film may be peeled or the characteristics may be deteriorated. Further, if another film is deposited thereon, quality of the film of such a layer is deteriorated as well. This means that the warp that is generated when forming the glass insulating layer on the metal substrate is a specific problem for the thin-film photovoltaic cells, not for other photovoltaic cells, and it is desired to suppress generation itself of the warp as much as possible.

### [Patent Documents]

[Patent Document 1] Japanese Laid-open Patent Publication No. 2006-80370
[Patent Document 2] Japanese Laid-open Patent Publication (Translation of PCT Application) No. 2007-502536
[Patent Document 3] Japanese Laid-open Patent Publication No. H11-140666

In order to suppress the warp that is generated when forming the glass insulating layer, there is a method to make coefficients of thermal expansion of the metal substrate and the glass insulating layer as close as possible (Patent Document 2, for example). Further, as the glass insulating layer is weak for a tensile stress, and if the tensile stress is applied, cracks are easily generated, there is a method to make the coefficient of thermal expansion of the glass insulating layer to be slightly smaller than the coefficient of thermal expansion of the metal substrate so that a compressional stress remains in the glass insulating layer (Patent Document 3, for example).

However, it is not generally performed to make the coefficient of thermal expansion of the glass insulating layer larger than the coefficient of thermal expansion of the metal substrate so that a tensile stress remains in the glass insulating layer, opposite to the example of Patent Document 3.

As described above, although various methods to reduce the warp of the metal substrate have been studied, the warp of the metal substrate after forming the glass insulating layer is not sufficiently suppressed.

### SUMMARY OF THE INVENTION

The present invention is made in light of the above problems, and provides a thin-film photovoltaic cell in which warp of a metal substrate is sufficiently suppressed even after a step of forming a glass insulating layer.

According to an embodiment, there is provided a thin-film photovoltaic cell including a metal substrate; a glass insulating layer formed on the metal substrate; a first electrode layer deposited on the glass insulating layer; a thin-film light absorption layer deposited on the first electrode layer; and a second electrode layer deposited on the thin-film light absorption layer, wherein the coefficient of thermal expansion of the glass insulating layer is larger than the coefficient of thermal expansion of the metal substrate for a predetermined value.

According to the disclosed technique, a thin-film photovoltaic cell is provided in which warp of a metal substrate is sufficiently reduced after a step of forming a glass insulating layer.

### BRIEF DESCRIPTION OF THE DRAWINGS

Fig. 1 is a cross-sectional view illustrating an example of a thin-film photovoltaic cell of a first embodiment;
Fig. 2 is a view illustrating an example of a manufacturing step of the thin-film photovoltaic cell of the first embodiment (No. 1);
Fig. 3 is a view illustrating an example of a manufacturing step of the thin-film photovoltaic cell of the first embodiment (No. 2);
Fig. 4 is a view illustrating an example of a manufacturing step of the thin-film photovoltaic cell of the first embodiment (No. 3);
Fig. 5 is a cross-sectional view illustrating an example of a thin-film photovoltaic cell of a second embodiment;
Fig. 6 is a view illustrating an example of a manufacturing step of the thin-film photovoltaic cell of the second embodiment (No. 1);
Fig. 7 is a view illustrating an example of a manufacturing step of the thin-film photovoltaic cell of the second embodiment (No. 2);
Fig. 8 is a view illustrating an example of a manufacturing step of the thin-film photovoltaic cell of the second embodiment (No. 3);
Fig. 9 is a view illustrating an example of a relationship of a warped amount of a metal substrate and a difference between a coefficient of thermal expansion of a glass insulating layer and a coefficient of thermal expansion of the metal substrate;
Fig. 10 is a photograph illustrating an example of a status of warp of the metal substrate (No. 1);
Fig. 11 is a photograph illustrating an example of a status of warp of the metal substrate (No. 2);
Fig. 12 is a photograph illustrating an example of a status of warp of the metal substrate (No. 3);
Fig. 13 is a view illustrating an example of a combination of the thickness of the metal substrate and the thickness of the glass insulating layer;
Fig. 14 is a view illustrating a range of Δ that satisfies L < ± 10 mm when the thickness of the glass insulating layer is 30 µm and the thickness of the metal substrate is varied; and
Fig. 15 is a view illustrating a range of Δ that satisfies L < ± 10 mm when the thickness of the metal substrate is 0.3 mm and the thickness of the glass insulating layer is varied.

### DETAILED DESCRIPTION OF THE PREFERRED EMBODIMENTS

The invention will be described herein with reference to illustrative embodiments. It is to be noted that, in the explanation of the drawings, the same components are given the same reference numerals, and explanations are not repeated.

Here, although a CIS-based compound thin-film photovoltaic cell is mainly exemplified in the following embodiment or the like, the present invention is applicable to a compound thin-film photovoltaic cell other than the CIS-based one or a general photovoltaic cell. As an example of the compound thin-film photovoltaic cell to which the present invention is applicable, other than the CIS-based one, a CZTS-based compound thin-film photovoltaic cell in which a thin-film light absorption layer is composed of a compound including copper (Cu), zinc (Zn), tin (Sn) and a chalcogen element (selenium (Se) or sulfur (S)), a CdTe-based compound thin-film photovoltaic cell in which a thin-film light absorption layer is composed of a compound including cadmium (Cd) and tellurium (Te), or the like may be used. Further, as an example of the general thin-film photovoltaic cell to which the present invention is applicable, an amorphous silicon thin-film photovoltaic cell in which a thin-film light absorption layer is composed of non-doped amorphous silicon or amorphous silicon doped with dopant, or the like may be used.

### (First embodiment)

### (Structure of thin-film photovoltaic cell of first embodiment)

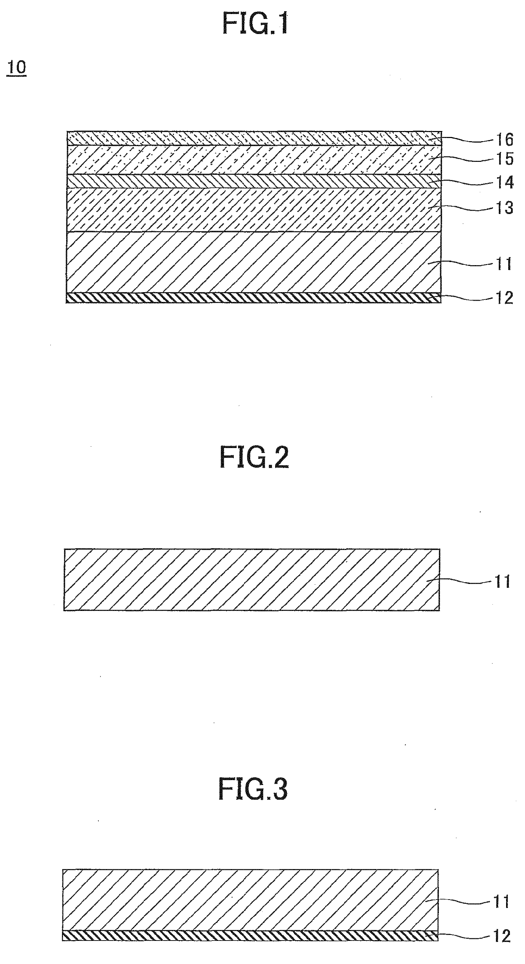

Fig. 1 is a cross-sectional view illustrating an example of a thin-film photovoltaic cell of the first embodiment. With reference to Fig. 1, a thin-film photovoltaic cell 10 includes a metal substrate 11, an anti-corrosion layer 12, a glass insulating layer 13, a first electrode layer 14, a thin-film light absorption layer 15 and a second electrode layer 16. In the thin-film photovoltaic cell 10, the glass insulating layer 13, the first electrode layer 14, the thin-film light absorption layer 15 and the second electrode layer 16 are stacked on one side of the metal substrate 11 in this order, and the anti-corrosion layer 12 is formed at another side of the metal substrate 11. Here, the anti-corrosion layer 12 may be arbitrarily included according to the purpose of the embodiment. Hereinafter, each element composing the thin-film photovoltaic cell 10 is explained.

In this application, in the substrate and layers that compose the compound thin-film photovoltaic cell 10, a surface at a light receiving side may be referred to as an "upper surface" and a surface opposite to this may be referred to as a "lower surface". Further, the upper surface of the metal substrate 11 may be particularly referred to as a "front surface", and the lower surface of the metal substrate 11 may be particularly referred to as a "back surface". Further, a side of the metal substrate 11 at which the thin-film light absorption layer 15 or the like is formed may be referred to as an "element forming surface side".

The metal substrate 11 is a portion that becomes a base body on which the glass insulating layer 13, the first electrode layer 14, the thin-film light absorption layer 15 and the second electrode layer 16 are formed. The metal substrate 11 is a substrate containing iron as a main constituent and further contains chromium (Cr), for example. The back surface is covered by the anti-corrosion layer 12. The thickness of the metal substrate 11 may be about 0.2 mm to 0.4 mm, for example.

As an example of the metal substrate 11, a stainless substrate may be used. Furthermore, as another example of the metal substrate 11, a ferrite-based stainless substrate may be used. The ferrite-based stainless substrate is preferable because its coefficient of thermal expansion is near 10 × 10⁻⁶ (1/K) that is a coefficient of thermal expansion of a CIS-based compound, which will be explained later. The metal substrate 11 may contain aluminium.

The stainless substrate is a substrate made of stainless steel. The stainless steel means chromium (Cr), or alloy steel containing chromium (Cr) and nickel (Ni) in which the content of chromium (Cr) is greater than or equal to 10.5%.

Here, the metal substrate 11 is not limited to the above stainless substrate, and a substrate whose main constituent is iron and containing less than 10.5% of chromium (Cr) may be used, for example. In this case, the substrate may further contain nickel (Ni).

In other words, the substrate whose main constituent is iron and containing chromium (Cr) may include various stainless substrates including a ferrite-based stainless substrate and a substrate containing a kind of metal same as the stainless substrate in which the content of chromium (Cr) is less than 10.5%.

Here, when the content of the chromium (Cr) is too small, there is a possibility that the coefficient of thermal expansion of the metal substrate 11 becomes large or the surface roughness becomes large and it is difficult to use the substrate as a substrate of a photovoltaic cell. Thus, it is preferable that chromium (Cr) is contained at least about 8%.

The anti-corrosion layer 12 is a layer provided to protect the metal substrate 11, when the thin-film photovoltaic cell 10 is a compound-based type and corrosive hydrogen selenide (H₂Se) gas or hydrogen sulfide (H₂S) gas is used at high temperature when manufacturing it, from corrosion due to such gas, for example. As the process by the hydrogen selenide (H₂Se) gas or the hydrogen sulfide (H₂S) is performed under high temperature such as 400 °C to 600 °C, for example, it is preferable to use an inorganic material such as silica, alumina or the like as the material, and it is preferable to form it by a sputtering method or the like.

Here, the anti-corrosion property required here is only limited within the operation period of the above step (about equal to or less than an hour), it is sufficient for the thickness of the anti-corrosion layer 12 to be thin as about 20 to 100 nm. Thus, influence of the existence of the anti-corrosion layer 12 to warp of the metal substrate 11 can be ignored.

The glass insulating layer 13 is formed on the upper surface of the metal substrate 11. When the thin-film photovoltaic cell 10 is a compound-based type, by considering that it is normal to integrate a plurality of cells in series to output high voltage, defects such as oil pits, scratches or the like, that cause leak are formed on the upper surface of the metal substrate 11, and the like, it is not preferable to provide a thin insulating layer such as that used for the anti-corrosion layer 12 on the upper surface of the metal substrate 11, even the film has similar insulation properties.

Thus, when the metal substrate 11 is used, it is preferable to adopt a thick insulating layer. This is because by covering the oil pits or the scratches by the thick film, influences of them can be removed and a high dielectric strength can be obtained. For this purpose, the glass insulating layer is preferable. Further, another reason to use the glass insulating layer is that an organic material cannot be used in the thin-film photovoltaic cell 10 because in the thin-film photovoltaic cell 10, a high temperature process is performed when forming the thin-film light absorption layer 15.

As such, as the material of the insulating layer formed on the upper surface of the metal substrate 11, it is preferable to use a glass. As an example of the glass, a glass or a low-melting glass may be used whose component is at least one selected from silica (SiO₂), CaO, B₂O₃, SrO, BaO, Al₂O₃, ZnO, ZrO₂ and MgO.

The glass insulating layer 13 may be constituted by a plurality of layers combining the above described materials, and in such a case, the glass insulating layer 13 may include a layer that has an alkali barrier function. The alkali barrier function is a function to prevent an excessive amount of alkali metal components such as sodium (Na), potassium (K) or the like from being diffused into the thin-film light absorption layer 15. It is preferable that the thickness of the layer that has the alkali barrier function is about 5 to 100 nm, for example.

It is preferable that the thickness of the glass insulating layer 13 is greater than or equal to 16 µm and less than or equal to 40 µm. Here, according to the studies by the present inventors, it is revealed that the conversion efficiency of the thin-film photovoltaic cell 10 is lowered when the thickness of the glass insulating layer 13 is less than 10 µm.

It is considered that this is because the surface roughness of the metal substrate 11 due to the above described oil pits, scratches or the like influences the surface smoothness of each layer formed on the glass insulating layer 13. Further, it is not preferable to form the thickness of the glass insulating layer 13 to be greater than 50 µm because the mechanical strength of the glass insulating layer 13 is lowered or the glass insulating layer 13 is easily delaminated or peeled from the metal substrate 11.

Further, it is preferable that the coefficient of thermal expansion of the glass insulating layer 13 is larger than the coefficient of thermal expansion of the metal substrate 11 for a predetermined value. Here, the predetermined value is 0.4 × 10⁻⁶ (1/K). However, by taking the thickness of the metal substrate 11 (greater than or equal to 0.2 mm and less than or equal to 0.4 mm) and the thickness of the glass insulating layer 13 (greater than or equal to 16 µm and less than or equal to 40 µm), which are assumed to be actually used, a measurement error of the coefficients of thermal expansion, an allowable range (less than ± 10 mm) of a warped amount of the metal substrate 11 or the like into account, the predetermined value may be greater than or equal to 0.03 × 10⁻⁶ (1/K) and less than or equal to 0.78 × 10⁻⁶ (1/K). A base for these values will be explained later.

The reason why it is preferable that the coefficient of thermal expansion of the glass insulating layer 13 is larger than the coefficient of thermal expansion of the metal substrate 11 for the predetermined value is because it is possible to reduce a warped amount of the metal substrate 11 in a step of forming the glass insulating layer 13 (about 600 °C to 800 °C).

The first electrode layer 14 is formed on the glass insulating layer 13. As the material of the first electrode layer 14, molybdenum (Mo) may be used, for example. As the material of the first electrode layer 14, another metal that has high corrosion resistance against hydrogen selenide

(H₂Se) or hydrogen sulfide (H₂S), for example, such as titanium (Ti), tungsten (W) or the like may be used. It is preferable that the thickness of the first electrode layer 14 is about a few dozen nm to a few µm, and may be, for example, 0.5 µm.

Here, an alkali barrier layer may be formed between the glass insulating layer 13 and the first electrode layer 14. The alkali barrier layer is a layer provided for preventing an excessive amount of alkali metal components such as sodium (Na), potassium (K) or the like from being diffused into the thin-film light absorption layer 15. As the material of the alkali barrier layer, silica (SiO₂) or the like may be used, for example. The thickness of the alkali barrier layer may be about 5 to 100 nm, for example.

The thin-film light absorption layer 15 is a layer composed of a p-type semiconductor and is formed on the first electrode layer 14. The thin-film light absorption layer 15 is a portion that photoelectrically converts irradiated sunlight to electrical energy. The photo current generated by the photoelectric conversion of the thin-film light absorption layer 15 can be extracted as current to outside from an electrode ribbon (copper film ribbon), not illustrated in the drawings, that is attached to either or both of the first electrode layer 14 and the second electrode layer 16 by solder or the like. The thickness of the thin-film light absorption layer 15 varies in accordance with a used thin-film material, however, for a case of the CIS-based compound thin film, it is preferable that the thickness is about a few hundred nm to a few dozen µm, and may be 1.5 µm, for example.

The thin-film light absorption layer 15 is a semiconductor thin-film and may be formed by an amorphous silicon thin-film, a compound thin-film such as CdTe based, CZTS based or CIS based or the like. For example, for a case of a CIS-based compound thin-film composed of IB-IIIB-VIB group elements, the material may be at least one kind of compound semiconductor including at least one kind of IB group element selected from a group consisting of Cu and Ag, at least one kind of IIIB group element selected from a group consisting of Al, Ga and In, and at least one kind of VIB group element selected from a group consisting of S and Se.

As a specific example of the compound, copper indium 2 selenide (CuInSe₂), copper indium 2 sulfide (CuInS₂), copper indium 2 sulfide-selenide (CuIn(SSe)₂), copper gallium 2 selenide (CuGaSe₂), copper gallium 2 sulfide (CuGaS₂), copper indium gallium 2 selenide (Cu(InGa)Se₂), copper indium gallium 2 sulfide (Cu(InGa)S₂), copper indium gallium 2 sulfide-selenide (Cu(InGa)(SSe)₂) or the like may be used.

Here, as the thin-film light absorption layer 15, a CZTS-based compound composed of copper (Cu), zinc (Zn), tin (Sn) and a chalcogen element may be used, for example. As an specific example of the compound, 2 copper zinc tin 4 selenide (Cu₂ZnSnSe₄), 2 copper zinc tin 4 sulfide (Cu₂ZnSnS₄), 2 copper zinc tin 4 sulfide-selenide (Cu₂ZnSn(SSe)₄) or the like may be used.

A buffer layer (not illustrated in the drawings) may be formed on the thin-film light absorption layer 15. When the thin-film light absorption layer 15 is a compound type, the buffer layer is a high resistance layer that has a function to prevent leakage of current from the thin-film light absorption layer 15. As the material of the buffer layer, a zinc compound (Zn(S, O, OH)) or the like may be used, for example. As the material of the buffer layer, zinc oxide (ZnO), zinc sulfide (ZnS), indium oxide (In₂O₃), indium sulfide (InS), an indium compound (In (S, O, OH)), cadmium sulfide (CdS) or the like may be used. The thickness of the buffer layer may be about a few nm to a few dozen nm, for example.

The second electrode layer 16 is a transparent layer made of an n-type semiconductor, and is formed on the thin-film light absorption layer 15. The second electrode layer 16 forms a PN junction between the thin-film light absorption layer 15, which is made of a p-type semiconductor, and further functions as a low resistance conductor. As the second electrode layer 16, a transparent conductive film such as a zinc oxide based thin-film (ZnO), an ITO thin-film, a tin oxide(SnO₂) or the like may be used, for example. When the zinc oxide based thin-film (ZnO) is used, it is preferable to add boron (B), aluminium (Al), gallium (Ga) or the like as a dopant so that the film can be made low resistance. The thickness of the second electrode layer 16 may be about 0.5 µm to 2.5 µm, for example.

Here, the thin-film photovoltaic cell 10 may be an integrated structure in which a plurality of cells are connected in series.

### (Method of manufacturing thin-film photovoltaic cell of first embodiment)

Next, a method of manufacturing the thin-film photovoltaic cell of the first embodiment is explained. Here, as an example, a method of manufacturing the CIS based compound thin-film photovoltaic cell in which the CIS-based compound thin-film is used as the thin-film light absorption layer 15 is explained. Fig. 2 to Fig. 4 are views illustrating an example of a manufacturing step of the thin-film photovoltaic cell of the first embodiment.

First, in a step illustrated in Fig. 2, the metal substrate 11 is prepared. As the metal substrate 11, a ferrite-based stainless substrate (SUS430, coefficient of thermal expansion is 10.4 × 10⁻⁶ (1/K)) including iron as a main constituent and further including chromium (Cr) may be used, for example. The thickness of the metal substrate 11 may be about 0.2 mm to 0.4 mm, for example.

Next, in a step illustrated in Fig. 3, the anti-corrosion layer 12 is formed on the back surface of the metal substrate 11 by depositing silica by a sputtering method, for example. The thickness of the anti-corrosion layer 12 may be about 20 nm to 100 nm, for example. Here, the anti-corrosion layer 12 is not necessarily provided according to the purpose of the embodiment.

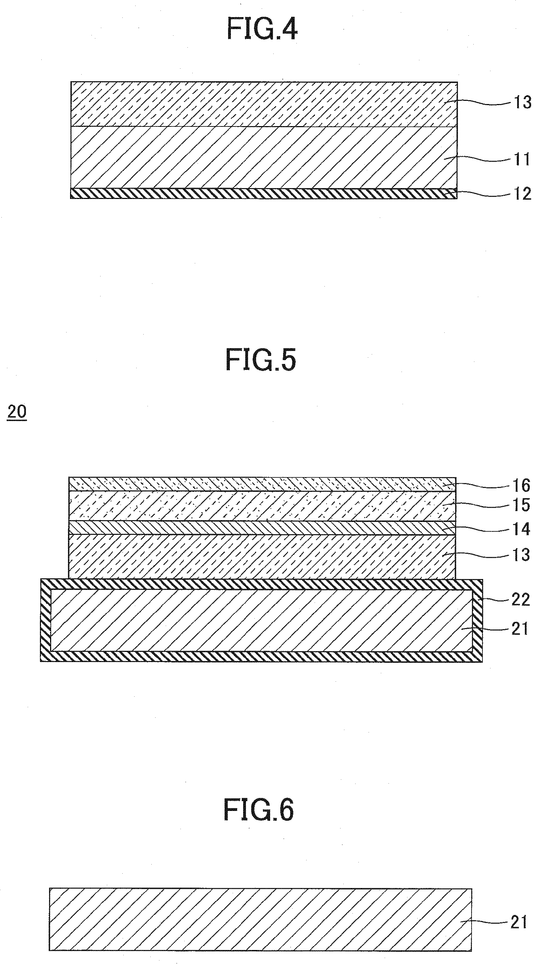

Next, in a step illustrated in Fig. 4, the glass insulating layer 13 is formed on the upper surface of the metal substrate 11. In this embodiment, a glass paste whose coefficient of thermal expansion is higher than the coefficient of thermal expansion of the metal substrate 11 for a predetermined value, and whose softening point is within a range of 600 °C to 800 °C was coated on the front surface of the metal substrate 11 by a slit coater. Here, although an optimum value of the predetermined value is 0.4 × 10⁻⁶ (1/K), by taking the thickness of the metal substrate 11 (greater than or equal to 0.2 mm and less than or equal to 0.4 mm) and the thickness of the glass insulating layer 13 (greater than or equal to 16 µm and less than or equal to 40 µm), which are assumed to be actually used, a measurement error of the coefficients of thermal expansion, an allowable range (less than ± 10 mm) of a warped amount of the metal substrate 11 or the like into account, the predetermined value may be greater than or equal to 0.03 × 10⁻⁶ (1/K) and less than or equal to 0.78 × 10⁻⁶ (1/K).

An example of the glass material that can be used as the glass paste that becomes the glass insulating layer 13 is as described above. Instead of the slit coater, the glass paste may be coated by a spray coater, screen printing, a dip coater, a spin coater or the like.

Next, the coated glass paste is heated at about 100 °C to 200 °C in air to dry the glass paste and vaporize organic solvent in the glass paste. Further, by heating and baking the dried glass paste at temperature greater than or equal to the softening point, the glass insulating layer 13 is formed. The thickness of the glass insulating layer 13 after being baked may be about 30 µm, for example. Here, as temperatures for the step of drying the glass paste and the step of heating and baking the glass paste are largely different, those steps may be performed in different apparatuses.

Further, as long as the above described relationship of the coefficients of thermal expansion between the metal substrate 11 and the glass insulating layer 13 is satisfied, the glass insulating layer 13 may be formed by a non-heating process such as sputtering or the like.

After the step of Fig. 4, by stacking the first electrode layer 14, the thin-film light absorption layer 15 made of a CIS-based compound thin-film and the second electrode layer 16 on the glass insulating layer 13 in this order, the CIS based compound thin-film photovoltaic cell that is an example of the thin-film photovoltaic cell 10 of the embodiment illustrated in Fig. 1 is completed.

Specifically, the first electrode layer 14 is deposited on the glass insulating layer 13 by a DC magnetron sputtering method or the like. The material of the first electrode layer 14 is molybdenum (Mo), the thickness is about 0.5 µm, for example. Alternatively, in depositing, the film may be deposited by an electron beam evaporation method or the like.

Next, copper indium gallium 2 sulfide-selenide (Cu(InGa)(SSe)₂) is deposited on the first electrode layer 14 as the thin-film light absorption layer 15, for example. The copper indium gallium 2 sulfide-selenide (Cu(InGa)(SSe)₂) may be deposited by forming a precursor film including copper (Cu), gallium (Ga), indium (In) and the like by a DC magnetron sputtering method, an evaporation method or the like, for example, and thereafter, introducing selenide by hydrogen selenide (H₂Se) and sulfide by hydrogen sulfide (H₂S) (introduction process of selenide/ sulfide) at temperature about 400 to 600 °C, for example. The thickness of the thin-film light absorption layer 15 may be about 1.5 µm, for example.

Here, instead of the copper indium gallium 2 sulfide-selenide (Cu(InGa)(SSe)₂), the above described copper indium 2 selenide (CuInSe₂), copper indium 2 sulfide (CuInS₂) or the like may be deposited as the thin-film light absorption layer 15. In this case, the film may be deposited by forming a precursor film including copper (Cu), indium (In) and the like, and thereafter, introducing selenide by hydrogen selenide (H₂Se) or sulfide by hydrogen sulfide (H₂S) at temperature about 400 to 600 °C, for example.

Further, the thin-film light absorption layer 15 may be deposited by vapor depositing copper (Cu), gallium (Ga), indium (In) and selenium (Se). Further, the thin-film light absorption layer 15 may be deposited by vapor depositing copper (Cu), gallium (Ga), indium (In) and sulfur (S). Further, the thin-film light absorption layer 15 may be deposited by vapor depositing copper (Cu), gallium (Ga), indium (In), selenium (Se) and sulfur (S). Further, the thin-film light absorption layer 15 may be deposited by a sputtering method, a mechanochemical process method, a screen printing method, a close-spaced sublimation method or the like. In any methods, heating on the metal substrate 11 is performed.

When the back surface of the metal substrate 11 is covered by the anti-corrosion layer 12, corrosion of the entire surface of the metal substrate 11 by hydrogen selenide (H₂Se), hydrogen sulfide (H₂S) or the like is suppressed.

After depositing the thin-film light absorption layer 15, in accordance with the necessity, a buffer layer may be deposited on the thin-film light absorption layer 15. The buffer layer may be deposited on the thin-film light absorption layer 15 by a Chemical Bath Deposition method(CBD method), a Metal Organic Chemical Vapor Deposition method (MOCVD method), an Atomic Layer Deposition method (ALD method) or the like, for example. The material, the thickness or the like of the buffer layer is as described above.

Next, the second electrode layer 16 is deposited on the thin-film light absorption layer 15 by a MOCVD method or the like. The second electrode layer 16 may be formed on the thin-film light absorption layer 15 by a sputtering method, an evaporation method, an Atomic Layer Deposition method (ALD method) or the like. As the material of the second electrode layer 16, ZnO doped with 3 group elements may be used, and its thickness may be about 1.0 µm, for example.

By the above described methods, the CIS based compound thin-film photovoltaic cell that is an example of the thin-film photovoltaic cell 10 of the embodiment as illustrated in Fig. 1 is completed. Here, separating grooves may be formed in the first electrode layer 14, the thin-film light absorption layer 15 and the second electrode layer 16 and may form an integrated structure in which cells, which are separated and formed into strip shapes by the separating grooves, are connected in series.

### (Second embodiment)

In the second embodiment, an example of a thin-film photovoltaic cell is explained in which a metal substrate (aluminium containing stainless substrate) is used where an alumina layer is formed at a surface thereof. For the aluminium containing stainless substrate, it is possible to form a uniform alumina layer at surface by a simple method of performing thermal oxidation on the surface. As the alumina layer thus formed is stable to corrosive gas that is used in a manufacturing step of the CIS based compound thin-film photovoltaic cell that is an example of the thin-film photovoltaic cell 10 of the above described first embodiment, the alumina layer is favorable for a new anti-corrosion layer to be used instead of the above described anti-corrosion layer 12 made of silica. In the second embodiment, the same components as those of the first embodiment are given the same reference numerals, and explanations are not repeated.

### (Structure of thin-film photovoltaic cell of second embodiment)

Fig. 5 is a cross-sectional view illustrating an example of a thin-film photovoltaic cell of the second embodiment. With reference to Fig. 5, a thin-film photovoltaic cell 20 is different from the thin-film photovoltaic cell 10 (see Fig. 1) in that the metal substrate 11 and the anti-corrosion layer 12 are substituted by a metal substrate 21 and an alumina layer 22.

In the thin-film photovoltaic cell 20, the alumina layer 22 is formed on the entirety of the metal substrate 21 containing aluminium (hereinafter, simply referred to as the metal substrate 21 except for the case otherwise mentioned). The glass insulating layer 13, the first electrode layer 14, the thin-film light absorption layer 15 and the second electrode layer 16 are formed on the upper surface of the metal substrate 21 via the alumina layer 22 in this order.

The metal substrate 21 is a portion that becomes a base body on which the glass insulating layer 13, the first electrode layer 14, the thin-film light absorption layer 15 and the second electrode layer 16 are formed. The metal substrate 21 is a substrate containing iron as a main constituent, further contains aluminium (Al) and chromium (Cr), for example, and the entire surface of the substrate is covered by the alumina layer 22 formed by thermal oxidation. The alumina layer 22 is used as an anti-corrosion layer that corresponds to the anti-corrosion layer 12 made of silica or the like explained in the first embodiment. The thickness of the metal substrate 21 may be about 0.2 mm to 0.4 mm, for example.

It is preferable that the content of aluminium (Al) in the metal substrate 21 is greater than or equal to 0.1 weight % and less than or equal to 6.0 weight %. When the content of aluminium (Al) in the metal substrate 11 is less than 0.1 weight %, it is not preferable because the alumina layer 22 is not sufficiently formed. When the content of aluminium (Al) of the metal substrate 21 exceeds 6.0 weight %, it is not preferable because the coefficient of thermal expansion of the metal substrate 21 becomes large.

As an example of the metal substrate 21, a stainless substrate containing aluminium (Al) may be used. Further, as another example of the metal substrate 21, a ferrite-based stainless substrate containing aluminium (Al) may be raised. It is preferable to use the ferrite-based stainless substrate because the coefficient of thermal expansion of the ferrite-based stainless substrate is close to 10 × 10⁻⁶ (1/K), which is the coefficient of thermal expansion of the CIS-based compound.

However, the metal substrate 21 is not limited to the above described stainless substrate containing aluminium (Al), and a substrate whose main constituent is iron and containing aluminium (Al) and less than 10.5% of chromium (Cr) may be used, for example. In this case, the substrate may further contain nickel (Ni).

In other words, the substrate whose main constituent is iron and containing aluminium (Al) and chromium (Cr) may include various stainless substrates including a ferrite-based stainless substrate containing aluminium (Al) and a substrate containing a kind of metal same as the stainless substrate containing aluminium (Al) in which the content of chromium (Cr) is less than 10.5%.

Further, in order to form a further dense alumina layer 22, the metal substrate 21 may contain silicon (Si).

The alumina layer 22 covers the entire surface of the metal substrate 21. The alumina layer 22 is a layer formed such that aluminium (Al) contained in the metal substrate 21 is diffused at the entire surface of the metal substrate 21 under a predetermined condition. In a point of view of improving the adhesion with the glass insulating layer 13, it is preferable that the thickness of the alumina layer 22 is 30 nm to 1 µm. Further, as the alumina layer 22 is thin, influence of the existence of this layer to warp of the metal substrate 21 can be ignored.

Next, the glass insulating layer 13, the first electrode layer 14, the thin-film light absorption layer 15 and the second electrode layer 16 are formed on the metal substrate 21 at the entire surface of which the alumina layer 22 is formed as such in this order. As each method is similar to that explained in the first embodiment, the explanation is not repeated.

### (Method of manufacturing thin-film photovoltaic cell of second embodiment)

Next, a method of manufacturing the thin-film photovoltaic cell of the second embodiment is explained. Here, as an example, a method of manufacturing the CIS based compound thin-film photovoltaic cell using the CIS-based compound thin-film as the thin-film light absorption layer 15 is explained. Fig. 6 to Fig. 8 are views illustrating an example of a manufacturing step of the thin-film photovoltaic cell of the second embodiment.

First, in a step illustrated in Fig. 6, the metal substrate 21 is prepared. As the metal substrate 21, a substrate containing iron as a main constituent and further containing aluminium (Al) and chromium (Cr) may be used, for example. Specifically, as the metal substrate 21, a ferrite-based stainless substrate (JFE20-5USR, coefficient of thermal expansion is 11.0 × 10⁻⁶ (1/K)) that contains 5.5% of aluminium may be used, for example. The thickness of the metal substrate 21 may be about 0.2 mm to 0.4 mm, for example.

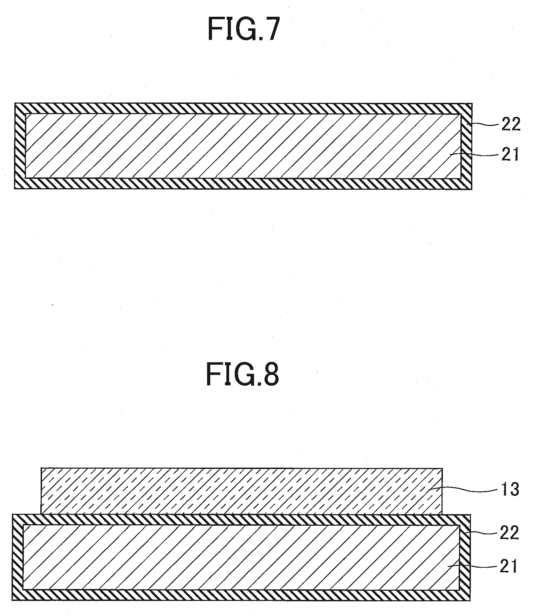

Next, in a step illustrated in Fig. 7, the metal substrate 21 is heated at temperature (this temperature may be referred to as pretreatment temperature) greater than or equal to 700 °C and less than 850 °C under air or atmosphere including oxygen to perform thermal oxidation and to form the alumina layer 22 by diffusing aluminium (Al) contained in the metal substrate 21 to the entire surface of the metal substrate 21. The thickness of the alumina layer 22 at this time is about 30 nm to 100 nm.

Here, the point that it is preferable that the pretreatment temperature is greater than or equal to 700 °C and less than 850 °C was experimentally found by the present inventors. According to the studies by the present inventors, when the pretreatment temperature is less than 700 °C, the adhesion between the insulating layer 13 is lowered because the alumina layer 22 is not sufficiently formed on the upper surface of the metal substrate 21. Further, if the pretreatment temperature is greater than or equal to 850 °C, the heat deformation amount of the metal substrate 21 becomes large and it becomes improper for the substrate of the compound thin-film photovoltaic cell, for which flatness is required.

Next, in a step illustrated in Fig. 8, the glass insulating layer 13 is formed on the alumina layer 22 that is formed at the upper surface of the metal substrate 21. In this embodiment, the glass paste whose coefficient of thermal expansion is greater than the coefficient of thermal expansion of the metal substrate 21 for the predetermined value and whose softening point is within a range of 600 °C to 800 °C is coated on the front surface of the metal substrate 21 by a slit coater. Although an optimum value of the predetermined value is 0.4 × 10⁻⁶ (l/K), by taking the thickness of the metal substrate 21 (greater than or equal to 0.2 mm and less than or equal to 0.4 mm) and the thickness of the glass insulating layer 13 (greater than or equal to 16 µm and less than or equal to 40 µm), which are assumed to be actually used, a measurement error of the coefficients of thermal expansion, an allowable range (less than ± 10 mm) of a warped amount of the metal substrate 21 or the like into account, the predetermined value may be greater than or equal to 0.03 × 10⁻⁶ (1/K) and less than or equal to 0.78 8 × 10⁻⁶ (1/K).

The glass material that can be used as the glass paste that becomes the glass insulating layer 13 is as described above. Instead of the slit coater, the glass paste may be coated by a spray coater, screen printing, a dip coater, a spin coater or the like.

Next, the coated glass paste is heated about 100 °C to 200 °C in air to dry the glass paste and vaporize organic solvent in the glass paste. Further, by heating and baking the dried glass paste at temperature greater than or equal to the above described softening point, the glass insulating layer 13 is formed. The thickness of the glass insulating layer 13 after being baked may be about 30 µm, for example. Here, as temperatures for the step of drying the glass paste and the step of heating and baking the glass paste are largely different, those steps may be performed in different apparatuses.

Further, as long as the above described relationship of the coefficients of thermal expansion between the metal substrate 11 and the glass insulating layer 13 is satisfied, the glass insulating layer 13 may be formed by a non-heating process such as sputtering or the like.

After the step of Fig. 8, by stacking the first electrode layer 14, the thin-film light absorption layer 15 made of a CIS-based compound thin-film and the second electrode layer 16 on the glass insulating layer 13, the CIS based compound thin-film photovoltaic cell that is an example of the thin-film photovoltaic cell 20 of the embodiment illustrated in Fig. 5 is completed. Specific contents are the same as those explained in the first embodiment.

### (Example 1)

In the thin-film photovoltaic cell of the first or second embodiment, suppression of warp was studied when a stainless substrate was used as the metal substrate.

Here, the step of forming the glass insulating layer in which the baking temperature is 600 °C to 800 °C or greater than or equal to that was mainly studied.

Specifically, a ferrite-based stainless substrate (SUS430) was used as the metal substrate and the coefficient of thermal expansion of the glass insulating layer that was formed thereon was varied. Then, a warped amount L of the metal substrate with the glass insulating layer was measured for each case. The size of the used metal substrate was length of about 1200 mm, the width of about 945 mm and the thickness of about 0.3 mm. Further, the thickness of the glass insulating layer was about 30 µm. Here, a metal scale (measure) was used for measuring the warped amount L.

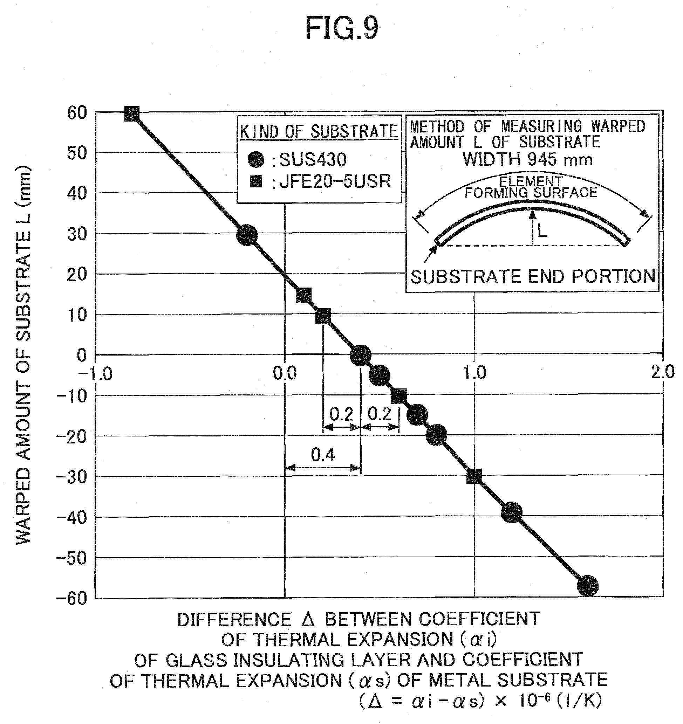

The result is illustrated in Table 1 and illustrated by marks • (black circular dots) in Fig. 9. Here, the coefficients of thermal expansion αi of the glass insulating layer in Table 1 and Fig. 9 are values measured based on JIS R 3102. Further, the coefficients of thermal expansion αs of the metal substrate in Table 1 and Fig. 9 are values measured based on JIS Z 2285.

**[Table 1]**

| αi (× 10⁻⁶ 1/K) | Δ=αi-αs (× 10⁻⁶ 1/K) | L (mm) |
|---|---|---|
| 10.2 | -0.2 | 30 |
| 10.8 | 0.4 | 0 |
| 10.9 | 0.5 | -5 |
| 11.1 | 0.7 | -15 |
| 11.2 | 0.8 | -20 |
| 11.6 | 1.2 | -39 |
| 12.0 | 1.6 | -57 |

In Fig. 9, the difference (Δ = αi - as) of the coefficient of thermal expansion (αi) of the glass insulating layer with respect to the coefficient of thermal expansion (αs = 10.4 × 10⁻⁶ (1/K)) of the used metal substrate was plotted in a horizontal axis. This means that zero in the horizontal axis indicates a case when the coefficients of thermal expansion α of both of them are equal and a plus direction indicates a case when the coefficient of thermal expansion (αi) of the glass insulating layer is greater than the coefficient of thermal expansion (αs) of the metal substrate, in other words, a status where a tensile stress is applied to the glass insulating layer. The ordinate axis indicates the warped amount L of the metal substrate with the glass insulating layer. Here, as illustrated in Fig. 9, the warp of the metal substrate is generated in its width direction. Further, as illustrated in Fig. 9, the warped amount L was illustrated by a millimeter unit such that a direction in which a center portion of the metal substrate at an element forming surface side protrudes upward with respect to substrate end portions is considered as positive.

From Table 1 and Fig. 9, it can be understood that when the difference (Δ = αi - αs) between the coefficient of thermal expansion (αi) of the glass insulating layer and the coefficient of thermal expansion (αs) of the metal substrate is minus, the metal substrate is warped such that to convex upwardly, the warp of the metal substrate is suppressed as Δ decreases, becomes minimum (zero) when Δ becomes 0.4 × 10⁻⁶ (1/K), and thereafter, the metal substrate is warped oppositely such that to convex downwardly.

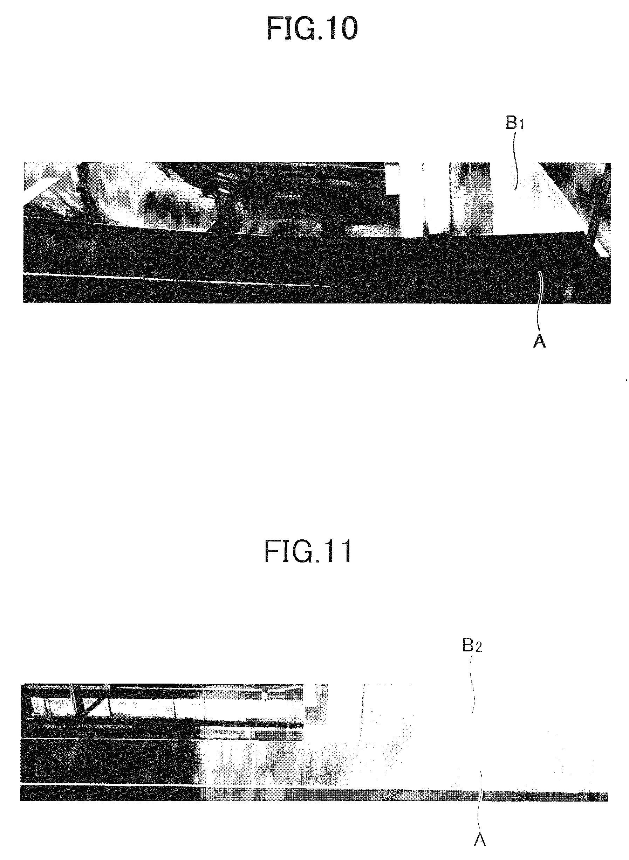

Fig. 10 to Fig. 12 are photographs each illustrating an example of a status of warp of the metal substrate. In Fig. 10 to Fig. 12, "A" indicates a surface plate, each of "B₁", "B₂" and "B₃" indicates a metal substrate. Each of the metal substrates B₁, B₂ and B₃ has a structure in which a glass insulating layer of 30 µm is formed on a substrate with a length of about 1200 mm, a width of about 945 mm and a thickness of about 0.3 mm. Each of Fig. 10 to Fig. 12 illustrates the status of the warp taken from a direction that is parallel to a short edge where the respective metal substrate B₁, B₂ or B₃ is mounted on the surface plate A under a state that the glass insulating layer (element forming surface side) is positioned upward. Here, as each of the metal substrates B₁, B₂ and B₃ is in a mirror surface state, background is shown. Further, in each image, a scale is also placed.

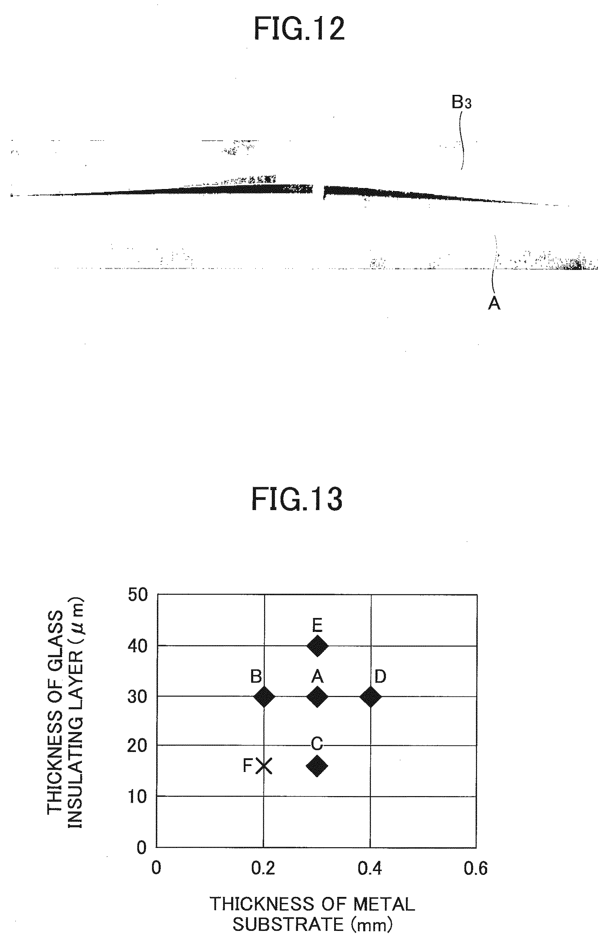

Fig. 10 illustrates a case when Δ is larger than 0.4 × 10⁻⁶ (1/K), and the element forming surface side is warped to convex downwardly when seen from a short edge side of the metal substrate B₁. Fig. 12 illustrates a case when Δ is smaller than 0.4 × 10⁻⁶ (1/K), and the element forming surface side is warped to convex upwardly when seen from a short edge side of the metal substrate B₃. The warps of the metal substrates B₁ and B₃ illustrated in Fig. 10 and Fig. 12, respectively, are large and the warp of about 20 mm is remained in each of them although they were horizontally placed. Meanwhile, Fig. 11 illustrates a case when Δ is 0.4 × 10⁻⁶ (1/K), warp is not recognized in the metal substrate B₂, and when placing the metal substrate B₂ on the surface plate A, the metal substrate B₂ adheres (contacts) the surface plate A.

Here, in Fig. 10 to Fig. 12, although the metal substrate is horizontally placed on the surface plate, the warped amount L illustrated in Fig. 9, Table 1 or the like is a value measured under a state that the metal substrate is vertically placed on the surface plate (under a state that a short edge of the metal substrate contacts the surface plate and a long edge is vertical to the surface plate), in order to avoid influence of gravity. When the warped amount, under a state that the metal substrate is vertically placed on the surface plate, is less than ± 10 mm, if the metal substrate is horizontally placed on the surface plate, as the metal substrate is deformed by dead load, the warped amount becomes almost zero as illustrated in Fig. 11, and the metal substrate adheres the surface plate. Here, as Fig. 11 illustrates the case when Δ is 0.4 × 10⁻⁶ (1/K), the warped amount is almost zero even under a state that the metal substrate is vertically placed on the surface plate.

As illustrated in Fig. 11, when the warped amount becomes almost zero, when depositing the first electrode layer 14 on the glass insulating layer 13 by a DC magnetron sputtering method or the like, the first electrode layer 14 with uniform quality of the film can be deposited, for example. On the other hand, when the warped amount becomes greater than or equal to ± 10 mm under a state that the metal substrate is vertically placed on the surface plate, the warp is not sufficiently corrected even when the metal substrate is horizontally placed on the surface plate. This means that the distance between a sputtering target and the metal substrate becomes different at positions when depositing the first electrode layer 14, and as a result, the first electrode layer 14 with uniform quality of the film cannot be deposited.

As such, it is extremely important to set Δ = αi - αs such that the warped amount L, illustrated in Table 1 or the like, becomes less than ± 10 mm.

### (Example 2)

Suppression of warp was studied when an aluminium containing stainless substrate was used as the metal substrate in the thin-film photovoltaic cell of the first or second embodiment.

Specifically, a ferrite-based stainless substrate (JFE20-5USR) containing aluminium was used as the metal substrate and the coefficient of thermal expansion of the glass insulating layer formed thereon was varied. Then, a warped amount of the metal substrate with the glass insulating layer was measured for each case. The size of the used metal substrate was; the length of about 1200 mm, the width of about 945 mm and the thickness of about 0.3 mm. Further, the thickness of the glass insulating layer was about 30 µm. A metal scale (measure) was used for measuring the warped amount L.

The result is illustrated in Table 2 and illustrated by marks ■ (black rectangular dots) in Fig. 9. Here, the coefficients of thermal expansion αi of the glass insulating layer in Table 2 and Fig. 9 are values measured based on JIS R 3102. Further, the coefficients of thermal expansion αs of the metal substrate in Table 2 and Fig. 9 are values measured based on JIS Z 2285.

**[Table 2]**

| αi (× 10⁻⁶ 1/K) | Δ=αi-αs (× 10⁻⁶ 1/K) | L (mm) |
|---|---|---|
| 10.2 | -0.8 | 59 |
| 10.8 | -0.2 | 29 |
| 11.1 | 0.1 | 14 |
| 11.2 | 0.2 | 9 |
| 11.6 | 0.6 | -11 |
| 12.0 | 1.0 | -31 |

From Table 2 and Fig. 9, it can be understood that when the difference (Δ = αi - as) between the coefficient of thermal expansion (αi) of the glass insulating layer and the coefficient of thermal expansion (αs) of the metal substrate is minus, the metal substrate is warped such that to convex upwardly, the warp of the metal substrate is suppressed as Δ decreases, becomes minimum (zero) when Δ becomes 0.4 × 10⁻⁶ (1/K), and thereafter, the metal substrate is warped oppositely such that to convex downwardly. This was similar for the case of Example 1 in which SUS430 was used as the metal substrate.

From the conventional observation, the warped amount L of the substrates should become minimum when the difference (Δ = αi - as) between the coefficient of thermal expansion (αi) of the glass insulating layer and the coefficient of thermal expansion (αs) of the metal substrate is zero. However, the results of the above described Examples 1 and 2 were completely different and the warped amount L became minimum when Δ was 0.4 × 10⁻⁶ (1/K), for each of the two metal substrates made of different materials. This means that it was revealed that warp of the metal substrate can be suppressed (to almost zero) by setting the coefficient of thermal expansion (αi) of the glass insulating layer larger than the coefficient of thermal expansion (αs) of the metal substrate for 0.4 × 10⁻⁶ (1/K).

For this reason, it is estimated that this is obtained as a composite result of temperature at which the glass insulating layer and the metal substrate become an adhered status, actual extended amount of them, temperature characteristics of Young's modulus of the metal substrate and the like and this is found as the difference of the coefficients of thermal expansion so far. The details are currently studied hard.

Here, when considering that an allowable range of a warped amount L of the metal substrate in actual depositing a film is less than ± 10 mm, variation of coefficients of thermal expansion of materials between lots such as the glass insulating layer or the metal substrate, a measurement error of the coefficients of thermal expansion or the like, it can be understood that it is preferable that Δ = αi - αs to be (0.4 ± 0.2) × 10⁻⁶ (1/K), in other words, to be a range greater than or equal to 0.2 × 10⁻⁶ (1/K) and less than or equal to 0.6 × 10⁻⁶ (1/K), when the thickness of the metal substrate is 0.3 mm and the thickness of the glass insulating layer is 30 µm.

The conventional observation of forming the glass insulating layer on the metal substrate regarding the coefficients of thermal expansion of both of them is, (1) a difference Δ of coefficients of thermal expansion of them is set to be as close as zero, or (2) the difference Δ is set to be minus so that the compressional stress is applied to the glass insulating layer from a view point of prevention of generation of cracks.

However, the present invention is different from both of them, and shows that the warp of the metal substrate can be suppressed by setting the difference Δ to be plus, in other words, to be the range greater than or equal to 0.2 × 10⁻⁶ (1/K) and less than or equal to 0.6 × 10⁻⁶ (1/K). This observation is obtained as a result of studies for solving a particular problem of suppression of warp in a specific structure of a thin-film photovoltaic cell, and shows a particular structure, different from conventionally known structures.

### (Example 3)

A combination of the metal substrate with the thickness of about 0.3 mm and the glass insulating layer with the thickness of about 30 µm was studied in Examples 1 and 2, if the thickness of the glass insulating layer becomes half, the warped amount becomes about half (as an approximate value from a theoretical formula of warp), for example. This means that the range of Δ by which the same warped amount (its limit value) is ensured becomes wider than the case of Examples 1 and 2. Thus, in Example 3, an appropriate range of Δ was studied when a combination of thicknesses of the metal substrate and the glass insulating layer were varied.

Specifically, the range of Δ, in which L < ± 10 mm was satisfied, was calculated for cases when the metal substrate and the glass insulating layer with thicknesses different from those of Examples 1 and 2 were combined. The combinations of them used for the calculation are "B", "C", "D" and "E" illustrated in Fig. 13. "B" is a combination of the metal substrate with the thickness of about 0.2 mm and the glass insulating layer with the thickness of about 30 µm, "C" is a combination of the metal substrate with the thickness of about 0.3 mm and the glass insulating layer with the thickness of about 16 µm, "D" is the metal substrate with the thickness of about 0.4 mm and the glass insulating layer with the thickness of about 30µm, and "E" is a combination of the metal substrate with the thickness of about 0.3 mm and the glass insulating layer with the thickness of about 40 µm.

The reason to set a minimum value of the thickness of the metal substrate as 0.2 mm is because if the thickness of the metal substrate is less than 0.2 mm (0.1 mm, for example) it is too thin and it is difficult for actualization. Further, the reason to set a minimum value of the thickness of the glass insulating layer as 16 µm is because if the thickness of the glass insulating layer is less than 20 µm, an insulation capability is lowered and 16 µm is considered as a limit thickness capable of being used when considering the insulation capability.

Here, "A" is a combination of the metal substrate with the thickness of about 0.3 mm and the glass insulating layer with the thickness of about 30 µm as illustrated in Examples 1 and 2. Further, although a combination of the metal substrate with the thickness of about 0.2 mm and the glass insulating layer with the thickness of about 16 µm as "F" can be also considered, for this case, the range of Δ becomes narrower than "C" and it is unnecessary to consider this case.

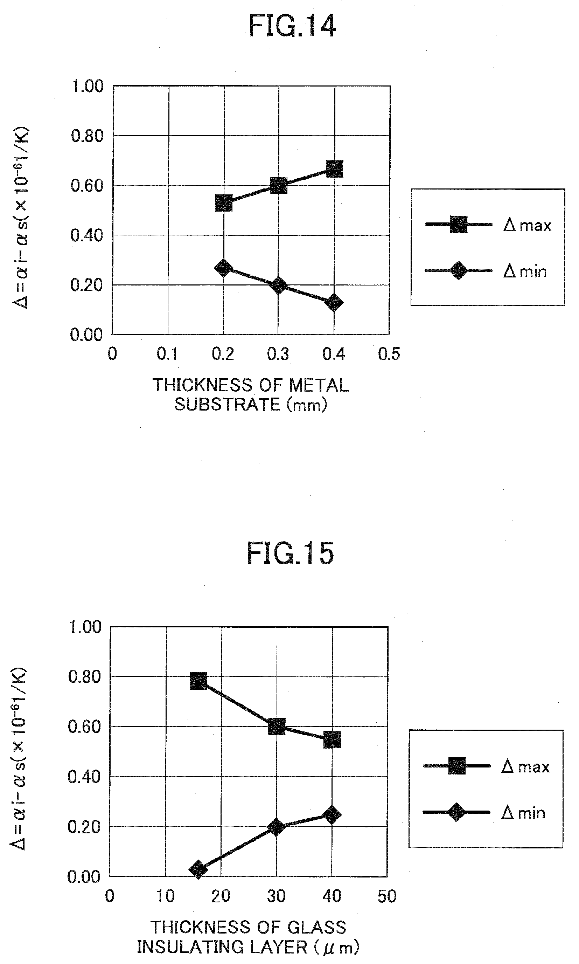

Calculated results are illustrated in Table 3, Fig. 14 and Fig. 15. Fig. 14 illustrates a range of Δ that satisfies L < ± 10 mm when the thickness of the glass insulating layer is 30 µm and the thickness of the metal substrate is varied. Further, Fig. 15 illustrates a range of Δ that satisfies L < ± 10 mm when the thickness of the metal substrate is 0.3 mm and the thickness of the glass insulating layer is varied. Here, Fig. 14 and Fig. 15 illustrate the minimum value (Δmin) and the maximum value (Δmax) of the range of Δ, and a range between Δmin and Δmax in each of the drawings is the range of Δ that satisfies L < ± 10 mm.

Here, the result that the warp becomes 0 when Δ = 0.40 × 10⁻⁶ (1/K) was the same for any combinations. Further, when Δ < 0.40 × 10⁻⁶ (1/K), the metal substrate warps such that the element forming surface side protrudes upwardly and when Δ > 0.40 × 10⁻⁶ (1/K), the metal substrate warps such that the element forming surface side protrudes downwardly.

**[Table 3]**

| THICKNESS OF METAL SUBSTRATE (mm) | THICKNESS OF GLASS INSULATING LAYER (µm) | (COEFFICIENT OF THERMAL EXPANSION OF GLASS INSULATING LAYER) - (COEFFICIENT OF THERMAL EXPANSION OF METAL SUBSTRATE) Δ=αi-αs (x 10⁻⁶ 1/K) | | |
|---|---|---|---|---|
| | | RANGE OF Δ | Δ min | Δ max |
| 0.3 | 16 | 0.03~0.78 | 0.03 | 0.78 |
| 0.3 | 30 | 0.20~0.60 | 0.20 | 0.60 |
| 0.3 | 40 | 0.25~0.55 | 0.25 | 0.55 |
| 0.2 | 30 | 0.27~0.53 | 0.27 | 0.53 |
| 0.4 | 30 | 0.13~0.67 | 0.13 | 0.67 |

As can be understood from Table 3 and Fig. 14, when providing the glass insulating layer with the thickness of 30 µm on the metal substrate with the thickness of 0.2 mm to 0.4 mm, if Δ is greater than or equal to 0.13 × 10⁻⁶ (1/K) and less than or equal to 0.67 ×10⁻⁶ (1/K), L < ± 10 mm can be satisfied. Further, as can be understood from Table 3 and Fig. 15, when providing the glass insulating layer with the thickness of 16 to 40 µm on the metal substrate with the thickness of 0.3 mm, if Δ is greater than or equal to 0.03 × 10⁻⁶ (1/K) and less than or equal to 0.78 × 10⁻⁶ (1/K), L < ± 10 mm can be satisfied. Considering these together, when providing the glass insulating layer with the thickness of 16 to 40 µm on the metal substrate with the thickness of 0.2 mm to 0.4 mm, if Δ is greater than or equal to 0.03 × 10⁻⁶ (1/K) and less than or equal to 0.78 × 10⁻⁶ (1/K), L < ± 10 mm can be satisfied.

As described above, in order to make the amount of warp small when the glass insulating layer is formed on the metal substrate, regardless of the thickness of the metal substrate or the thickness of the glass insulating layer, it is optimum to make a difference (Δ = αi - as) between the coefficient of thermal expansion (αs) of the metal substrate and the coefficient of thermal expansion (αi) of the glass insulating layer to 0.4 × 10⁻⁶ (1/K).

However, when considering the thickness of the metal substrate (greater than or equal to 0.2 mm and less than or equal to 0.4 mm) or the thickness of the glass insulating layer (greater than or equal to 16 µm and less than or equal to 40 µm) that are actually used, a measurement error of the coefficients of thermal expansion, an allowable range of the warped amount of the metal substrate (less than 10 mm) or the like, it can be said that the difference (Δ = αi - as) of the coefficient of thermal expansion (αs) of the metal substrate and the coefficient of thermal expansion (αi) of the glass insulating layer may be greater than or equal to 0.03 × 10⁻⁶ (1/K) and less than or equal to 0.78 × 10⁻⁶ (1/K).

Of course, if the specification of the thickness of the metal substrate or the thickness of the glass insulating layer is determined, a range of Δ = αi - αs that corresponds to it may be set. For example, when the thickness of the metal substrate is 0.3 mm and the thickness of the glass insulating layer is 30 µm, Δ = αi - αs may be greater than or equal to 0.2 × 10⁻⁶ (1/K) and less than or equal to 0.6 × 10⁻⁶ (1/K). Further, when it is desired to suppress the warped amount L to be further smaller than ± 10 mm or the like, a value of a range that is narrower than the above described range may be set while having 0.4 × 10⁻⁶ (1/K) as a center.

Although preferred embodiments and examples have been specifically illustrated and described, it is to be understood that minor modifications may be made therein without departing from the spirit and scope of the invention as defined by the claims.

The present application is based on and claims the benefit of priority of Japanese Priority Application No. 2013-078104 filed on April 3, 2013, the entire contents of which are hereby incorporated by reference.

### [Numerals]

- 10, 20: thin-film photovoltaic cell
- 11, 21: metal substrate
- 12: anti-corrosion layer
- 13: glass insulating layer
- 14: first electrode layer
- 15: thin-film light absorption layer
- 16: second electrode layer
- 22: alumina layer

## Claims

1. A thin-film photovoltaic cell comprising:
a metal substrate;
a glass insulating layer formed on the metal substrate;
a first electrode layer deposited on the glass insulating layer;
a thin-film light absorption layer deposited on the first electrode layer; and
a second electrode layer deposited on the thin-film light absorption layer,
wherein the coefficient of thermal expansion of the glass insulating layer is larger than the coefficient of thermal expansion of the metal substrate for a predetermined value.

2. The thin-film photovoltaic cell according to claim 1,
wherein the glass insulating layer is formed by baking.

3. The thin-film photovoltaic cell according to claim 1,
wherein the predetermined value is greater than or equal to 0.03 × 10⁻⁶ (1/K) and less than or equal to 0.78 × 10⁻⁶ (1/K) .

4. The thin-film photovoltaic cell according to claim 1,
wherein the thickness of the metal substrate is greater than or equal to 0.2 mm and less than or equal to 0.4 mm, and
wherein the thickness of the glass insulating layer is greater than or equal 16 µm and less than or equal to 40 µm.

5. The thin-film photovoltaic cell according to claim 1,
wherein the metal substrate contains iron as a main constituent and further contains chromium (Cr).

6. The thin-film photovoltaic cell according to claim 5,
wherein the metal substrate is a stainless substrate.

7. The thin-film photovoltaic cell according to claim 6,
wherein the metal substrate is a ferrite-based stainless substrate.

8. The thin-film photovoltaic cell according to claim 5,
wherein the metal substrate further contains aluminium (Al).

9. The thin-film photovoltaic cell according to claim 1,
wherein the thin-film light absorption layer is a compound thin-film.

10. The thin-film photovoltaic cell according to claim 9,
wherein the thin-film light absorption layer is a CIS-based compound thin-film.

11. The thin-film photovoltaic cell according to claim 1,
wherein the thin-film light absorption layer is a layer formed by performing a heat process step.
